# EUROPÄISCHE PATENTANMELDUNG

(11) **EP 1 130 775 A2**
(43) Veröffentlichungstag der Anmeldung: **05.09.2001**
(21) Anmeldenummer: 01100788.7
(22) Anmeldetag: 13.01.2001
(51) Int. Cl.: H03J 1/00

(54) **Verfahren zur Programmierung von Funkempfängern und Messgeräten, wobei die Daten als Bar-Code Daten in einen Empfänger eingegeben werden**

(30) Priorität: 17.02.2000 DE 10008398
(71) Anmelder: Deutsche Telekom AG, 53113 Bonn (DE)
(72) Erfinder: Rudolph, Dietmar, Prof. Dr., 14163 Berlin (DE)

(57) **Zusammenfassung**

Bei Funkempfängern für Rundfunk, Fernsehen und kommerziellen Funk werden die Empfangsfrequenzen derzeit noch ausschließlich manuell eingestellt. Auch die Aktualisierung der Service-Programme bei Messgeräten auf Grund der technischen Weiterentwicklung wird derzeit ausschließlich durch manuelle Eingriffe in das Innere der Geräte umgesetzt. Die vorliegende Erfindung bietet die Möglichkeit, Service-Informationen für den Funkempfang bzw. bei Messgeräten in Form einer Programmierung umzusetzen, indem die Service-Informationen als Bar-Codes eingelesen werden. Damit wird eine fehlerfreie Eingabe der Informationen gewährleistet. Der Bar-Codes-Leser kann in den Funkempfänger bzw. in das Messgerät integriert werden oder als separates Gerät über Kabel oder mittels optischer Übertragung mit dem Funkempfänger bzw. Messgerät verbunden sein.

## Beschreibung

Die Erfindung betrifft die Eingabe von Service-Informationen (z.B. Empfangsfrequenzen, Messprogramme) für die Senderwahl bei Funkempfängern bzw. für die Servicefunktionen bei Messgeräten.

### Stand der Technik

Es ist im Bereich des Handels heute üblich, die Preise mittels Bar-Codes auf den Waren anzubringen. Dies erleichtert das Einlesen des Preises in die Kasse erheblich und beschleunigt diesen Vorgang wesentlich.

Bei Rundfunkempfängern ist es dagegen auch heute noch üblich, Frequenzen über Tasten oder Drehknöpfe einzustellen. Dies ist mühsam und fehlerbehaftet. Bei Videorekordern gibt es dagegen bereits vereinzelt die Möglichkeit, Programm-Beiträge und deren Sendezeitpunkt per Bar-Code einzulesen. Allerdings werden in dieser Anwendung keine Frequenzen eingelesen, da sich die Auswahl auf wenige Programmanbieter (ARD, ZDF, ...) beschränkt.

Speziell für Kurzwellen (KW) "Weltempfang" werden selbst für einzelne Programme viele verschiedene Frequenzen und Frequenzbänder benutzt, die je nach Empfangsregion unterschiedlich sind und die ausbreitungsbedingt in Abhängigkeit von Tages- und Jahreszeit geändert werden. Zusätzlich sind i. a. an einem Empfangsort nicht alle dort vorgesehenen Frequenzen tatsächlich auch empfangbar, oder der Empfänger ist starken Ausbreitungsschwankungen unterworfen, verbunden mit frequenz-selektivem "Fading".

Die KW-Rundfunkanstalten verlesen daher in regelmäßigen Abständen pro Tag ihre jeweils demnächst verfügbaren Sendefrequenzen. Es ist jedoch mühsam und fehlerbehaftet, die Frequenzen aufzuschreiben. Zusätzlich besteht die Mühe, diese dann auch noch richtig in den Empfänger einzugeben.

Gewünscht wird daher ein einfaches und robustes Verfahren, das auch von Laien angewendet werden kann und eine fehlerfreie Eingabe der Informationen (z.B. Empfangsfrequenzen) gewährleistet.

### Lösung des Problems für den Rundfunkempfang

Voraussetzung für die Lösung ist das Vorhandensein von Bar-Codes für die Frequenzen der Rundfunkstationen. Diese Bar-Codes könnten über die Rundfunkveranstalter z. B. via Internet oder über Programmzeitschriften oder die schon heute üblichen Kurzwellen-Jahrbücher verbreitet werden. Bar-Codes sind für Laien (hier Rundfunkteilnehmer) einfacher zu handhaben als z. B. Magnetstreifen, wie sie sich auf Kreditkarten befinden.

Für den Empfänger ist dann nur noch ein Bar-Code-Leser in einfachster Ausführung notwendig, um die Frequenz-Informationen einlesen zu können. Damit ließen sich die "Weltempfänger" entsprechend (vor-) programmieren.

Bei dem zukünftigen digitalen Rundfunkempfang hätte dies zusätzlich den Vorteil, dass der Empfänger alle Frequenz-Informationen erhält und automatisch die beste Empfangsfrequenz auswählen kann. Damit entfällt das mühsame Suchen nach dem gewünschten Sender. Da bei digitaler Übertragung auch die Frequenzlisten übertragen werden, lassen sich die Frequenz-Informationen fortlaufend aktualisieren.

Ein solcher Bar-Code-Leser kann für einen Rundfunkempfänger erfindungsgemäß in folgenden Varianten ausgeführt sein:
1. Der Leser hat die Form eines Stiftes und ist über Verbindungskabel mit dem Rundfunkempfänger verbunden.
2. Der Leser ist in das Gehäuse des Rundfunkempfängers integriert (z.B. für portable Empfänger) und dort an einer geeigneten, gut zugänglichen Postion untergebracht (z.B. an einer Ecke).

### Lösung des Problems für Messgeräte

Die Anwendung beschränkt sich naturgemäß nicht auf Rundfunkempfänger, sondern ist in gleicher oder ähnlicher Weise auch für Fernsehempfänger und allgemeine (kommerzielle) Funkempfänger anwendbar.

Daneben ist genauso eine Anwendung zum Programmieren von Messgeräten denkbar. Die Variante 1. ist besonders für größere und stationäre Empfänger oder Messgeräte geeignet, während Variante 2. sich für portable Geräte besonders eignet. Ein portables Gerät wird über den Bar-Code hinweg bewegt.

## Patentansprüche

1. Verfahren zur Programmierung von Funkempfängern und Messgeräten,
**dadurch gekennzeichnet**,
dass die Programmierung die Eingabe von funktions- und/oder servicebedingten Informationen betrifft, die bei Funkempfängern (Radio, Fernsehen, kommerzielle Funkempfänger) die aktuellen Empfangsfrequenzen und bei Messgeräten Weiterentwicklungen für die Service-Programme beinhalten,
dass die Service-Informationen als Bar-Codes eingegeben werden, indem die Informationen in das Format von Bar-Codes umgesetzt und mittels einer optischen Lesevorrichtung eingelesen werden, und
dass der Bar-Codes-Leser in das Gehäuse des Funkempfängers bzw. Messgerätes integriert ist oder als separates Gerät eingesetzt wird, das mit dem Funkempfänger bzw. Messgerät in Verbindung steht.

2. Verfahren nach Anspruch 1, **dadurch gekennzeichnet**, dass bei Verwendung eines Bar-Codes-Lesers als separates Gerät die Verbindung zum Funkempfänger bzw. Messgerät über ein Kabel erfolgt, das aus metallenen Leitern und/oder optischen Fasern bestehen kann.

3. Verfahren nach Anspruch 1. und 2., **dadurch gekennzeichnet**, dass bei Verwendung eines Bar-Codes-Leser als separates Gerät die Verbindung zum Funkempfänger bzw. Messgerät als optische Übertragung ausgelegt ist.
